# EUROPÄISCHE PATENTSCHRIFT

(11) **EP 2 434 303 B1**
(45) Veröffentlichungstag und Bekanntmachung des Hinweises auf die Patenterteilung: **31.05.2017**
(21) Anmeldenummer: 11181418.2
(22) Anmeldetag: 15.09.2011
(51) Int. Cl.: G01R 27/26, G01R 31/327, H01H 47/00

(54) **Verfahren zur Prüfung der Funktionsfähigkeit der elektromagnetischen Auslösung eines Schalters, insbesondere eines Leistungsschalters für Niederspannungen und eine Prüfschaltung dafür.**
Method for testing the functionality of the electromagnetic triggering of a switch, in particular a circuit breaker for low voltages and test circuit therefor.
Procédé de contrôle de la capacité de fonctionnement du déclenchement électromagnétique d'un commutateur, notamment d'un disjoncteur pour basses tensions et circuit de test pour cela.

(30) Priorität: 27.09.2010 DE 102010041449
(43) Veröffentlichungstag der Anmeldung: 28.03.2012
(73) Patentinhaber: Siemens Aktiengesellschaft, 80333 München (DE)
(72) Erfinder: Driehorn, Thomas, 12207 Berlin (DE); Müller, Gerd, 14612 Falkensee (DE)

(56) Entgegenhaltungen:
- DE-A1- 3 715 591
- DE-A1- 4 126 534
- DE-A1- 4 406 250
- DE-A1- 19 603 319
- US-A- 5 777 536

## Beschreibung

Verfahren zur Prüfung der Funktionsfähigkeit der elektromagnetischen Auslösung eines Schalters, insbesondere eines Leistungsschalters für Niederspannungen, und eine Prüfschaltung dafür.

Die Erfindung betrifft ein Verfahren zur Prüfung der Funktionsfähigkeit der elektromagnetischen Auslösung eines Schalters, insbesondere eines Leistungsschalters für Niederspannungen, gemäß dem Oberbegriff des Anspruchs 1 und eine Prüfschaltung gemäß dem Oberbegriff des Anspruchs 6. Leistungsschalter für Niederspannungen sind bekannt und dienen in Anlagen zur Stromverteilung als Schutzschalter. Durch den Schalter verläuft für jede Stromphase ein Leiter, der jeweils von einem Wechselstrom durchflossen wird. Bei geschlossenem Schalter liegen Kontaktelemente des Schalters aneinander an. Im Schalter ist je ein Stromwandler unmittelbar an dem Leiter jeder Stromphase angeordnet, der ein vom fließenden Strom abhängiges elektrisches Signal abgibt, welches ausgewertet wird. Der so erfasste Strom wird von einem Überstromauslöser (Auslöseeinheit) mit einem Stromgrenzwert verglichen und bei Überschreitung löst der Überstromauslöser den Schalter aus. Der Auslösefall tritt insbesondere dann ein, wenn ein anhaltender Über- oder Kurzschlussstrom auftritt. Der Stromgrenzwert ist parameter- und kennlinienabhängig.

Zur Öffnung des Schalters werden die Schaltkontakte mit Hilfe einer Auslösewelle geöffnet, welche von einem Schaltschloss unter Vorspannung gehalten wird. Das Schaltschloss wird mittels eines Auslösemagneten (Elektromagneten) entklinkt, der eine Wicklung aufweist, durch welche im Auslösefall ein Strom geschickt wird. Das Entklinken des Schaltschlosses gibt die in einem Federspeicher gespeicherte mechanische Energie frei. Die Freigabe der gespeicherten Energie erfolgt durch einen Auslösemagneten mit relativ geringer Kraft. Der Auslösemagnet wird vom Überstromauslöser angesteuert und das Schaltschloss mittels des verschiebbaren Auslösemagneten (Stößels) entklinkt.

Die Funktion des Schalters ist damit direkt von der Funktion des Auslösemagneten abhängig. Das Nichtfunktionieren des Auslösemagneten durch Drahtbruch oder mechanische Blockierung kann schwerwiegende Folgen haben.

Aus der DE4126534A1 ist insbesondere ein Verfahren zur Messung und Bewertung der Induktivität einer elektromagnetischen Relaisspule mit Anker bekannt, bei dem ein Kondensator zu einer Erregerspule eines elektromagnetischen Relais und einer Gleichspannungsquelle parallel geschaltet wird. Ein Messstromkreis ist parallel zur Erregerspule angeschlossen, um die Entladung des Kondensators über die Erregerspule des Relais bei geschlossenen Relaiskontakten zu messen. Anhand des abklingenden Spannungsverlaufs wird die Periodendauer und mit deren Hilfe ein erster Induktivitätswert bei anliegendem Anker bestimmt. Liegt der Induktivitätswert zwischen zwei vorgegebenen Werten Mmax und Mmin, liegt das Relais bzgl. Ansprech- und Abfallspannung im zulässigen magnetischen Toleranzbereich. Um die Abbrandreserve des Relais störungsfrei zu ermitteln, wird die Messung bei gerade öffnenden Relaiskontakten wiederholt.

Weiter ist aus US5777536A ein entsprechender Leistungsschalter bekannt.

Die Aufgabe der Erfindung ist es, ein Verfahren zur Funktionsüberprüfung des Auslösers für einen Leistungsschalter bereitzustellen.

Die Aufgabe wird durch die Merkmale des Anspruchs 1 und des Anspruchs 6 gelöst; die Unteransprüche stellen vorteilhafte Ausgestaltungen dar.

Die Lösung sieht vor, dass im Nichtauslösefall a) das Schaltelement (S) während des Schalterbetriebs geöffnet ist und b) der Schwingkreis fortlaufend zum Schwingen angeregt wird, dass das Schwingkreis-Signal mittels eines Frequenz-Spannungs-Wandlers in eine Spannung umgewandelt wird und dass anhand der Spannung jeweils eine Signalbewertung zur Funktionsfähigkeit des Auslösemagneten vorgenommen und bei einem Fehler ein Fehler-Signal ausgegeben wird. Die Erfindung löst die Prüfung der Funktionsfähigkeit der elektromagnetischen Auslösung dadurch, dass die Induktivität des Auslösemagneten durch eine spezielle externe Beschaltung einen Schwingkreis bildet, dessen Resonanzfrequenz maßgeblich durch die Induktivität des Auslösemagneten bestimmt wird. Eine Änderung der Induktivität bei eingefahrenem und ausgefahrenem Auslösemagneten oder teilweisem Wicklungsschluss bewirkt jeweils eine Änderung der Resonanzfrequenz des Schwingkreises. Bei einem Drahtbruch der Wicklung (Magnetspule) kommt es zu einem Zusammenbruch des Schwingkreises bzw. Abbruch der Schwingungen.

Durch Auswertung des vom Schwingkreis erzeugten Signals kann daher eine Aussage getroffen werden über
a) die Position des Auslösemagneten (eingefahren oder ausgefahren) und
b) einen möglichen Drahtbruch oder eine Verschlechterung der elektrischen Eigenschaften des Auslösemagneten.

Somit kann sowohl die mögliche Bereitschaft (Nichtvorliegen eines Drahtbruchs) als auch der Erfolg eines Auslöseversuchs (Nachweis der Zustandsänderung/Positionsänderung nach einem Betätigungsversuch) überwacht werden.

Zweckmäßigerweise wird bei fehlender Resonanzfrequenz ein Fehler-Signal ausgegeben.

Mit Vorteil wird anhand der Resonanzfrequenz der Betriebszustand (die Position) des Auslösemagneten erfasst.

Technisch einfach ist es, wenn die Frequenz mittels einer Frequenz-Spannungs-Wandlung in eine Spannung umgewandelt und die umgewandelte Spannung bewertet wird, wobei die Signalbewertung die jeweilige Position des verschiebbaren Auslösemagneten einschließt. Die Auswertung der vom Schwingkreis erzeugten Schwingungen kann durch direkte oder indirekte Frequenzmessung erfolgen. Bei der direkten Frequenzmessung muss das Signal einer geeigneten Zählapparatur zugeführt und über der Zeit ausgewertet werden. Bei der indirekten genügt es, das Signal durch eine weitere elektronische Beschaltung in ein frequenzeigenes Spannungs- oder Stromsignal umzuwandeln und dieses auszuwerten.

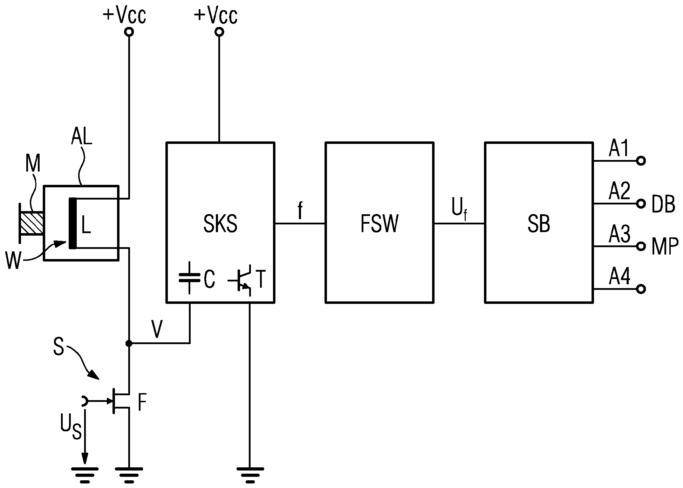

Die Erfindung wird nachfolgend anhand einer Zeichnung näher beschrieben, deren einzige Figur eine schematische Darstellung einer Prüfschaltung eines Leistungsschalters für Niederspannungen zeigt. Von dem Schalter ist in der Figur lediglich ein Auslösemagnet M dargestellt, der eine Wicklung W (Magnetspule) umfasst und eine Induktivität L bildet. Durch den Schalter verläuft (bei einem mehrpoligen Schalter für jede Stromphase) ein Leiter, der von einem Wechselstrom durchflossen wird. Bei geschlossenem Schalter liegen Kontaktelemente des Schalters aneinander an. Unmittelbar am Leiter ist ein Stromwandler angeordnet, der ein vom fließenden Strom abhängiges elektrisches Signal abgibt, welches ausgewertet wird. Der so erfasste Strom wird von einem Überstromauslöser AL (einer Auslöseeinheit) jeweils mit einem vorgegebenen Stromgrenzwert verglichen und bei Überschreitung wird der Schalter von dem Überstromauslöser AL ausgelöst. Der Auslösefall tritt insbesondere bei einem Überstrom und einem Kurzschlussstrom ein. Der Stromgrenzwert ist parameter- und kennlinienabhängig; die Auslösung und Öffnung des Schalters erfolgt bei anhaltender Überlast oder Kurzschluss.

Zur Öffnung des Schalters werden die Schaltkontakte mit Hilfe einer Auslösewelle geöffnet, welche von einem Schaltschloss unter Vorspannung gehalten wird. Das Schaltschloss wird im Auslösefall mittels eines Auslösemagneten M (Elektromagneten) entklinkt, durch dessen Wicklung W ein Strom geschickt wird, indem der Überstromauslöser AL ein Fehler-Signal, hier eine Spannung Us, an ein elektronisches Schaltelement S, hier einen FET F, gibt, der dadurch durchgeschaltet wird. Das Entklinken des Schaltschlosses gibt die in einem Federspeicher gespeicherte mechanische Energie frei.

Ohne die Spannung Us ist die mit der Versorgungsspannung Vcc verbundene Induktivität L jeweils von Masse getrennt.

Mittels eines Schwingkreisschaltung SKS erfolgt eine Anschaltung eines Kondensators C an die Induktivität L (über die Verbindung V und die Versorgungsspannung Vcc), die zusammen einen Schwingkreis bilden. Die Schwingkreisschaltung SKS sorgt dafür, dass der Schwingkreis ständig angeregt wird. Dies ist in der Figur durch den Transistor T schematisch dargestellt. Der Schwingkreis weist eine Resonanzfrequenz (Eigenfrequenz) auf, die hier mittels eines Frequenz-Spannungs-Wandlers in eine Spannung Uf umgewandelt wird. Die Spannung Uf wird an eine Signalbewertungsschaltung SB gegeben, welche anhand der Abweichung von einem vorgegebenen Spannungswert ein Fehler-Signal ausgibt. Wie die Figur zeigt, verfügt die Signalbewertung SB dabei über vier Ausgänge A1, A2, A3, A4, die das Fehler-Signal jeweils für einen anderen Fehler ausgeben. So zeigt ein Fehler-Signal am Ausgang A2 an, dass ein Drahtbruch DB der Wicklung W des Auslösemagneten M vorliegt. Der Ausgang A3 wiederum weist ein Fehler-Signal auf, wenn der Auslösemagnet M seine Auslöse-Position nicht eingenommen hat.

## Patentansprüche

1. Verfahren zur Prüfung der Funktionsfähigkeit der elektromagnetischen Auslösung eines Schalters, insbesondere eines Leistungsschalters für Niederspannungen, der Schaltkontakte aufweist, die mit Hilfe einer Auslösewelle geöffnet werden, welche von einem Schaltschloss unter Vorspannung gehalten und durch einen verschiebbaren Auslösemagneten (M) entklinkt wird, der dazu eine Wicklung (W) aufweist, durch welche zum Auslösen ein Strom geschickt wird, indem ein Überstromauslöser (AL) eine Spannung (Us) als Fehler-Signal an ein elektronisches Schaltelement (S) gibt, das dadurch die Wicklung (W) auf Masse durchschaltet und den Auslösestrom erzeugt,
wobei die Wicklung (W) als Induktivität (L) in einen Schwingkreis geschaltet wird, der Schwingkreis mittels einer Schwingkreisschaltung (SKS) zu Schwingungen angeregt wird und anhand eines vom Schwingkreis gebildeten Schwingkreis-Signals die Funktionsfähigkeit des Auslösemagneten (M) bewertet wird,
**dadurch gekennzeichnet,**
**dass** im Nichtauslösefall a) das Schaltelement (S) während des Schalterbetriebs geöffnet ist, b) der Schwingkreis fortlaufend zum Schwingen angeregt wird, und c) bei nicht anliegender Spannung (Us) die mit einer Versorgungsspannung (Vcc) verbundene Induktivität (L) jeweils von der Masse getrennt ist,
**dass** das Schwingkreis-Signal mittels eines Frequenz-Spannungs-Wandlers in eine Spannung (Uf) umgewandelt wird und dass anhand der Spannung (Uf) jeweils eine Signalbewertung zur Funktionsfähigkeit des Auslösemagneten (M) vorgenommen und bei einem Fehler ein Fehler-Signal ausgegeben wird.

2. Verfahren nach Anspruch 1,
**dadurch gekennzeichnet,**
**dass** die Spannung (Uf) der Resonanzfrequenz des Schwingkreises entspricht.

3. Verfahren nach Anspruch 2,
**dadurch gekennzeichnet,**
**dass** die Signalbewertung anhand der Spannung (Uf) die jeweilige Position des verschiebbaren Auslösemagneten (M) einschließt.

4. Verfahren nach einem der Ansprüche 1 - 3,
**dadurch gekennzeichnet,**
**dass** bei fehlender Spannung (Uf) und damit Resonanzfrequenz ein Fehler-Signal ausgegeben wird.

5. Verfahren nach Anspruch 4,
**dadurch gekennzeichnet,**
**dass** durch das Fehler-Signal auch ein Drahtbruch (DB) der Wicklung (W) angezeigt wird.

6. Prüfschaltung mit einem Schalter, der Schaltkontakte aufweist, wobei die Schaltkontakte dazu eingerichtet sind, mit Hilfe einer Auslösewelle geöffnet zu werden und von einem Schaltschloss unter Vorspannung gehalten und durch einen verschiebbaren Auslösemagneten (M) entklinkt zu werden, wobei der Auslösemagnet (M) eine Wicklung (W) aufweist, durch welche zum Auslösen ein Strom geschickt werden kann,
wobei die Prüfschaltung weiterhin aufweist:
- einen Überstromauslöser (AL) zum Geben einer Spannung (Us) als Fehler-Signal an ein elektronisches Schaltelement (S), das dadurch die Wicklung (W) auf Masse durchschaltet und einen Auslösestrom erzeugt,
- eine Schwingkreisschaltung (SKS) zum Anregen eines Schwingkreises zu Schwingungen, wobei die Wicklung (W) als Induktivität (L) in den Schwingkreis geschaltet ist
**dadurch gekennzeichnet,**
**dass** a) das Schaltelement (S) dazu eingerichtet ist, im Nichtauslösefall während des Schalterbetriebs geöffnet zu sein, b) die Schwingkreisschaltung (SKS) dazu eingerichtet ist, im Nichtauslösefall den Schwingkreis fortlaufend zum Schwingen anzuregen, und c) bei nicht anliegender Spannung (Us) die mit der Versorgungsspannung (Vcc) verbundene Induktivität jeweils von der Masse getrennt ist,
**dass** ein Frequenz-Spannungs-Wandler dazu eingerichtet ist, das Schwingkreis-Signal in eine Spannung (Uf) umzuwandeln; und dass die Prüfschaltung dazu eingerichtet ist, anhand der Spannung (Uf) jeweils eine Signalbewertung zur Funktionsfähigkeit des Auslösemagneten (M) vorzunehmen und bei einem Fehler ein Fehler-Signal auszugeben.

7. Prüfschaltung nach Anspruch 6,
**dadurch gekennzeichnet,**
**dass** der Schalter als Leistungsschalter für Niederspannungen ausgestaltet ist.

8. Prüfschaltung nach Anspruch 6 oder 7
**dadurch gekennzeichnet,**
**dass** der Frequenz-Spannungs-Wandler dazu eingerichtet ist, das Schwingkreis-Signal in die Spannung (Uf) umzuwandeln, die der Resonanzfrequenz des Schwingkreises entspricht.

9. Prüfschaltung nach einem der Ansprüche 6 bis 8
**dadurch gekennzeichnet,**
**dass** die Prüfschaltung dazu eingerichtet ist, bei der Signalbewertung anhand der Spannung (Uf) die jeweilige Position des verschiebbaren Auslösemagneten (M) einzuschließen.

10. Prüfschaltung nach einem der Ansprüche 6 bis 9
**dadurch gekennzeichnet,**
**dass** die Prüfschaltung dazu eingerichtet ist, bei fehlender Spannung (Uf) und damit Resonanzfrequenz ein Fehler-Signal auszugeben.

11. Prüfschaltung nach einem der Ansprüche 6 bis 10
**dadurch gekennzeichnet,**
**dass** die Prüfschaltung dazu eingerichtet ist, durch das Fehler-Signal einen Drahtbruch (DB) der Wicklung (W) anzuzeigen.

## Claims

1. Method for testing the functionality of the electromagnetic tripping of a switch, in particular of a circuit breaker for low voltages, which has switching contacts that are opened with the aid of a tripping shaft, which is held prestressed by a switching mechanism and is unlatched by a movable tripping magnet (M), which for this purpose has a winding (W) through which a current is sent for tripping, by virtue of the fact that an overcurrent release (AL) passes a voltage (Us) as fault signal to an electronic switching element (S), which as a result interconnects the winding (W) to earth and generates the tripping current,
wherein the winding (W) is connected as an inductance (L) in a resonant circuit, the resonant circuit is excited to effect oscillations by means of a resonant circuitry (SKS) and the functionality of the tripping magnet (M) is assessed using a resonant circuit signal formed by the resonant circuit, **characterized**
**in that**, in the non-tripping situation, a) the switching element (S) is open during switch operation, b) the resonant circuit is continuously excited to oscillate and c) the inductance (L) that is connected to a supply voltage (Vcc) is in each case isolated from ground in the absence of a voltage (Us),
**in that** the resonant circuit signal is converted to a voltage (Uf) by means of a frequency-voltage converter,
and **in that**, on the basis of the voltage (Uf), in each case a signal assessment of the functionality of the tripping magnet (M) is performed and, in the event of a fault, a fault signal is output.

2. Method according to Claim 1, **characterized in that** the voltage (Uf) corresponds to the resonant frequency of the resonant circuit.

3. Method according to Claim 2, **characterized in that** the signal assessment on the basis of the voltage (Uf) includes the respective position of the movable tripping magnet (M).

4. Method according to one of Claims 1-3, **characterized in that** a fault signal is output in the absence of a voltage (Uf) and thereby in the absence of a resonant frequency.

5. Method according to Claim 4, **characterized in that** a broken wire (DB) in the winding (W) is also indicated by the fault signal.

6. Test circuit comprising a switch, which has switching contacts, wherein the switching contacts are configured to be opened with the aid of a tripping shaft and held prestressed by a switching mechanism and unlatched by a movable tripping magnet (M), wherein the tripping magnet (M) has a winding (W) through which a current can be sent for tripping, wherein the test circuit furthermore has:
- an overcurrent release (AL) for passing a voltage (Us) as fault signal to an electronic switching element (S), which as a result interconnects the winding (W) to ground and generates a tripping current,
- a resonant circuitry (SKS) to excite a resonant circuit to effect oscillations, wherein the winding (W) is connected as an inductance (L) in the resonant circuit,
**characterized**
**in that** a) the switching element (S) is configured, in the non-tripping situation, to be open during switch operation, b) the resonant circuitry (SKS) is configured, in the non-tripping situation, to continuously excite the resonant circuit to oscillate and c) the inductance (L) that is connected to the supply voltage (Vcc) is in each case isolated from ground in the absence of a voltage (Us),
**in that** a frequency-voltage converter is configured to convert the resonant circuit signal to a voltage (Uf);
and **in that** the test circuit is configured, on the basis of the voltage (Uf), to perform in each case a signal assessment of the functionality of the tripping magnet (M) and, in the event of a fault, to output a fault signal.

7. Test circuit according to Claim 6, **characterized in that** the switch is embodied as a circuit breaker for low voltages.

8. Test circuit according to Claim 6 or 7, **characterized in that** the frequency-voltage converter is configured to convert the resonant circuit signal to the voltage (Uf), which corresponds to the resonant frequency of the resonant circuit.

9. Test circuit according to one of Claims 6 to 8, **characterized in that** the test circuit is configured to include the respective position of the movable tripping magnet (M) in the signal assessment on the basis of the voltage (Uf).

10. Test circuit according to one of Claims 6 to 9, **characterized in that** the test circuit is configured to output a fault signal in the absence of a voltage (Uf) and thereby in the absence of a resonant frequency.

11. Test circuit according to one of Claims 6 to 10, **characterized in that** the test circuit is configured to indicate a broken wire (DB) in the winding (W) by the fault signal.

## Revendications

1. Procédé de contrôle de la capacité de fonctionnement du déclenchement électromagnétique d'un commutateur, notamment d'un disjoncteur pour basses tensions, qui présente des contacts de commutation qui s'ouvrent à l'aide d'un arbre de déclenchement qui est maintenu sous précontrainte par un verrou de commutation et est libéré par un aimant de déclenchement coulissant (M) qui comporte, à cet effet, un enroulement (W) traversé par un courant pour déclencher du fait qu'un déclencheur à surintensité (AL) fournit une tension (Us) en tant que signal d'erreur à un élément de commutation électronique (S) qui, de ce fait, commute l'enroulement (W) à la masse et génère le courant de déclenchement, l'enroulement (W) étant commuté en tant qu'inductance (L) sur un circuit oscillant, le circuit oscillant étant mis en oscillation au moyen d'un montage de circuit oscillant (SKS) et la capacité de fonctionnement de l'aimant de déclenchement (M) étant évaluée à l'aide d'un signal de circuit oscillant formé par le circuit oscillant,
**caractérisé en ce que**,
en cas de non-déclenchement, a) l'élément de commutation (S) est ouvert pendant le fonctionnement du commutateur, b) le circuit oscillant est mis continuellement en oscillation et c) en cas de non-application d'une tension (Us), l'inductance (L) reliée à une tension d'alimentation (Vcc) est respectivement coupée de la masse ;
le signal de circuit oscillant est converti en une tension (Uf) au moyen d'un convertisseur fréquence-tension et
respectivement une évaluation de signal relative à la capacité de fonctionnement de l'aimant de déclenchement (M) est effectuée à l'aide de la tension (Uf) et, en cas d'erreur, un signal d'erreur est émis.

2. Procédé selon la revendication 1, **caractérisé en ce que** la tension (Uf) correspond à la fréquence de résonnance du circuit oscillant.

3. Procédé selon la revendication 2, **caractérisé en ce que** l'évaluation du signal à l'aide de la tension (Uf) inclut la position respective de l'aimant de déclenchement coulissant (M).

4. Procédé selon l'une des revendications 1 - 3, **caractérisé en ce que**, en l'absence de tension (Uf) et donc de fréquence de résonnance, un signal d'erreur est émis.

5. Procédé selon la revendication 4, **caractérisé en ce qu'**est également signalée, par le signal d'erreur, une rupture de fil (DB) de l'enroulement (W).

6. Circuit de contrôle comportant un commutateur qui présente des contacts de commutation, les contacts de commutation étant conçus pour s'ouvrir à l'aide d'un arbre de déclenchement et être maintenu sous précontrainte par un verrou de commutation et être libéré par un aimant de déclenchement coulissant (M), l'aimant de déclenchement (M) comportant, à cet effet, un enroulement (W) pouvant être traversé par un courant pour déclencher, le circuit de contrôle comportant en outre :
- un déclencheur à surintensité (AL) pour appliquer une tension (Us) en tant que signal d'erreur à un élément de commutation électronique (S) qui, de ce fait, commute l'enroulement (W) à la masse et génère un courant de déclenchement,
- un montage de circuit oscillant (SKS) pour mettre un circuit oscillant en oscillation, l'enroulement (W) étant commuté en tant qu'inductance (L) sur le circuit oscillant,
**caractérisé en ce que** :
a) l'élément de commutation (S) est conçu pour être ouvert pendant le fonctionnement du commutateur en cas de non-déclenchement, b) le montage de circuit oscillant (SKS) est conçu pour mettre continuellement le circuit oscillant en oscillation en cas de non-déclenchement et c) en cas de non-application d'une tension (Us), l'inductance reliée à la tension d'alimentation (Vcc) est respectivement coupée de la masse ;
un convertisseur fréquence-tension est conçu pour convertir le signal de circuit oscillant en une tension (Uf) et
le circuit de contrôle est conçu pour procéder, à l'aide de la tension (Uf), à une évaluation de signal relative à la capacité de fonctionnement de l'aimant de déclenchement (M) et pour émettre un signal d'erreur en cas d'erreur.

7. Circuit de contrôle selon la revendication 6, **caractérisé en ce que** le commutateur est réalisé en tant que disjoncteur pour basses tensions.

8. Circuit de contrôle selon la revendication 6 ou 7, **caractérisé en ce que** le convertisseur fréquence-tension est conçu pour convertir le signal de circuit oscillant en la tension (Uf) qui correspond à la fréquence de résonnance du circuit oscillant.

9. Circuit de contrôle selon l'une des revendications 6 à 8, **caractérisé en ce que** le circuit de contrôle est conçu pour inclure, lors de l'évaluation de signal à l'aide de la tension (Uf), la position respective de l'aimant de déclenchement coulissant (M).

10. Circuit de contrôle selon l'une des revendications 6 à 9, **caractérisé en ce que** le circuit de contrôle est conçu pour émettre un signal d'erreur en l'absence de tension (Uf) et donc de fréquence de résonnance.

11. Circuit de contrôle selon l'une des revendications 6 à 10, **caractérisé en ce que** le circuit de contrôle est conçu pour signaler une rupture de fil (DB) de l'enroulement (W) par le signal d'erreur.
